# EUROPEAN PATENT APPLICATION

(11) **EP 3 296 754 A1**
(43) Date of publication of application: **21.03.2018**
(21) Application number: 17191655.4
(22) Date of filing: 18.09.2017
(51) Int. Cl.: G01R 31/02, H02H 7/18

(54) **ENERGY STORAGE DEVICE AND LOAD DETECTION CIRCUIT THEREOF**

(30) Priority: 19.09.2016 CN 201621062646 U
(71) Applicant: Optimum Battery Co., Ltd., Shenzhen City, Guangdong 518118 (CN)
(72) Inventor: WANG, Qiang, Shenzhen, Guangdong 518118 (CN); WU, Kuan, Shenzhen, Guangdong 518118 (CN)
(74) Representative: Fry, Emma Leland

(57) **Abstract**

A load detection circuit (20) includes a first switch (21), a second switch (22), a low voltage output module (25), a high voltage output module (30), a detection module (50), and a control module (60). The detection module (20) detects states of a load (80) and outputs a detected result to the control module (60). The control module (60) determines whether the load (80) is normal and connected, according to the detected result. When the control module (60) determines that the load (80) is connected and short-circuited, or the load (80) is connected and open-circuited, or the load (80) is disconnected, the control module (60) controls the high voltage output module (30) to stop working, controls the second switch (22) to be turned off, and controls the first switch (21) to be turned on periodically. When the first switch (21) is turned on, the detection module (50) is powered by the low voltage output module (25). The present invention further provides an energy storage device (100) with the load detection circuit (20).

## Description

### BACKGROUND OF THE INVENTION

### Field of the Invention

This invention relates to energy storage devices, and more particular, to an energy storage device having a load detection circuit.

### Description of the Related Art

Energy storage devices are used to power loads with stored energy. However, when a load powered by an energy storage device is short-circuited, the energy storage device will be damaged.

It is desirable to provide an invention, which can overcome the problems and limitations mentioned above.

### SUMMARY OF THE INVENTION

The present invention is directed to an energy storage device and a load detection circuit of the energy storage device that substantially obviates one or more of the problems due to limitations and disadvantages of the related art.

In an aspect of the present invention, there is provided a load detection circuit comprising: a first switch and a second switch; a low voltage output module configured to output a low voltage; a high voltage output module configured to output a high voltage; a detection module electrically coupled to the low voltage output module through the first switch, and electrically coupled to the high voltage output module through the second switch; and a control module electrically coupled to the first switch, the second switch, the detection module, and the high voltage output module; wherein the control module controls the first switch to be turned on periodically, when the first switch is turned on, the detection module is powered by the low voltage output module through the first switch, the detection module detects states of a load and outputs a detected result to the control module, and the control module determines whether the load is normal and connected, according to the detected result; wherein when the control module determines that the load is normal and connected, the control module controls the high voltage output module to work, controls the first switch to be turned off, and controls the second switch to be turned on, the detection module and the load are powered by the high voltage output module through the second switch; and wherein when the control module determines that the load is connected and short-circuited, or the load is connected and open-circuited, or the load is disconnected, the control module controls the high voltage output module to stop working, controls the second switch to be turned off, and controls the first switch to be turned on periodically.

In another aspect of the present invention, there is provided an energy storage device comprising: an energy storage module and a load detection circuit; the energy storage module comprising a battery pack; the load detection circuit comprising a first switch and a second switch; a low voltage output module electrically coupled to the battery pack, and configured to convert a voltage outputted from the battery pack into a low voltage; a high voltage output module electrically coupled to the battery pack, and configured to convert the voltage outputted from the battery pack into a high voltage; a detection module electrically coupled to the low voltage output module through the first switch, and electrically coupled to the high voltage output module through the second switch; and a control module electrically coupled to the first switch, the second switch, the detection module, and the high voltage output module; wherein the control module controls the first switch to be turned on periodically, when the first switch is turned on, the detection module is powered by the low voltage output module through the first switch, the detection module detects states of a load and outputs a detected result to the control module, and the control module determines whether the load is normal and connected, according to the detected result; wherein when the control module determines that the load is normal and connected, the control module controls the high voltage output module to work, controls the first switch to be turned off, and controls the second switch to be turned on, the detection module and the load are powered by the high voltage output module through the second switch; and wherein when the control module determines that the load is connected and short-circuited, or the load is connected and open-circuited, or the load is disconnected, the control module controls the high voltage output module to stop working, controls the second switch to be turned off, and controls the first switch to be turned on periodically.

It is to be understood that both the foregoing general description and the following detailed description are exemplary and explanatory and are intended to provide further explanations of the invention as claimed.

### BRIEF DESCRIPTION OF THE DRAWINGS

Implementations of the present technology will now be described, by way of example only, with reference to the attached drawings. It may be understood that these drawings are not necessarily drawn to scale, and in no way limit any changes in form and detail that may be made to the described embodiments by one skilled in the art without departing from the spirit and scope of the described embodiments.
FIG. 1 is a block schematic diagram of an energy storage device provided by one embodiment of the present invention; wherein the energy storage device comprises an energy storage module and a load detection circuit; the an energy storage module comprises a battery pack; the load detection circuit comprises a high voltage output module and a detection module, the detection module comprises a detection unit and a first output unit, and the high voltage output module comprises a second output unit.
FIG. 2 is a circuit diagram of the detection unit of FIG. 1.
FIG. 3 is a circuit diagram of the first output unit of FIG. 1.
FIG. 4 is a circuit diagram of the second output unit of FIG. 1.
FIG. 5 is a schematic diagram of the battery pack of FIG. 1.

### DETAILED DESCRIPTION OF THE PREFERRED EMBODIMENTS

In order to make the purposes, technical solutions, and advantages of the present invention be clearer, the present invention will be further described in detail hereafter with reference to the accompanying drawings and embodiments. However, it will be understood by those of ordinary skill in the art that the embodiments described herein can be practiced without these specific details. In other instances, methods, procedures and components have not been described in detail so as not to obscure the related relevant feature being described. Also, it should be understood that the embodiments described herein are only intended to illustrate but not to limit the present invention.

Several definitions that apply throughout this disclosure will be presented. The term "coupled" is defined as connected, whether directly or indirectly through intervening components, and is not necessarily limited to physical connections. The connection can be such that the objects are permanently connected or releasably connected. The term "comprise", when utilized, means "include, but not necessarily limited to"; it specifically indicates open-ended inclusion or membership in a so-described combination, group, series and the like.

It should be noted that references to "an" or "one" embodiment in this disclosure are not necessarily to the same embodiment, and such references mean "at least one."

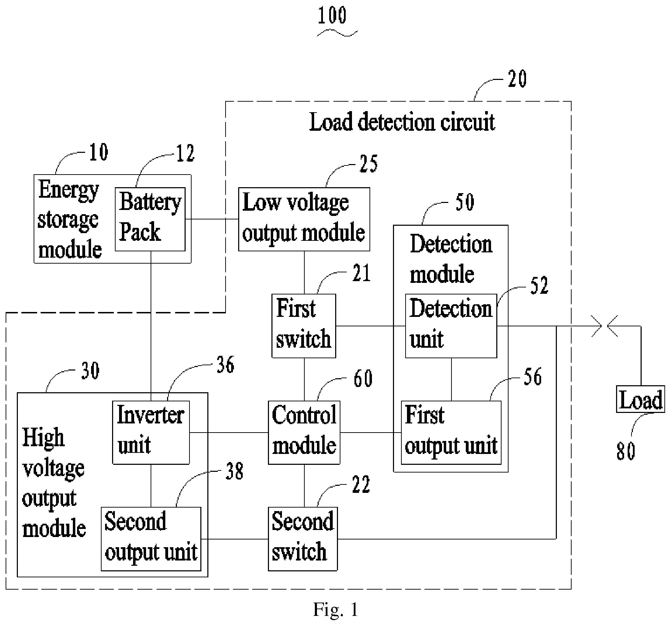

Fig. 1 illustrates a block schematic diagram of an energy storage device 100 provided by one embodiment of the present invention. The energy storage device 100 comprises an energy storage module 10 and a load detection circuit 20. The energy storage module 10 comprises a battery pack 12. The load detection circuit 20 comprises a first switch 21, a second switch 22, a low voltage output module 25, a high voltage output module 30, a detection module 50, and a control module 60. The battery pack 12 is electrically coupled to the low voltage output module 25 and the high voltage output module 30. The detection module 50 is electrically coupled to the low voltage output module 25 through the first switch 21, and electrically coupled to the high voltage output module 30 through the second switch 22. The control module 60 is electrically coupled to the high voltage output module 30, the first switch 21, the second switch 22, and the detection module 50.

The low voltage output module 25 is configured to convert a voltage outputted from the battery pack 12 into a low voltage. The high voltage output module 30 is configured to convert the voltage outputted from the battery pack 12 into a high voltage. The control module 60 is configure to control the first switch 21 to be turned on periodically. When the first switch 21 is turned on, the detection module 50 is powered by the low voltage output module 25 through the first switch 21. The detection module 50 detects states of a load 80 and outputs a detected result to the control module 60. The states of the load 80 comprises the load 80 being normal and connected, the load 80 being connected and short-circuited, the load 80 being connected and open-circuited, and the load 80 being disconnected. When the first switch 21 is turned off, the detection module 50 does not work. That is, when the first switch 21 is turned on, the detection module 50 is powered to work; when the first switch 21 is turned off, the detection module 50 does not work. The detection module 50 works periodically.

The control module 60 determines whether the load 80 is normal and connected, according to the detected result received from the detection module 50. When the control module 60 determines the load 80 being normal and connected, the control module 60 controls the high voltage output module 30 to work, controls the first switch 21 to be turned off, and controls the second switch 22 to be turned on; the detection module 50 and the load 80 are powered by the high voltage output module 30 through the second switch 22. When the control module 60 determines that the load 80 is connected and short-circuited, or the load 80 is connected and open-circuited, or the load 80 is disconnected, the control module 60 controls the high voltage output module 30 to stop working, controls the second switch 22 to be turned off, and controls the first switch 21 to be turned on periodically.

The detection module 50 comprises a detection unit 52 and a first output unit 56. The detection unit 52 is electrically coupled to the low voltage output module 25 through the first switch 21, electrically coupled to the high voltage output module 30 through the second switch 22, and electrically coupled to the control module 60 though the first output unit 56. The detection unit 52 is configured to detect the states of the load 80 and output a detected state signal to the first output unit 56. The first output unit 56 is configured to process the detected state signal to generate the detected result, and output the detected result to the control module 60.

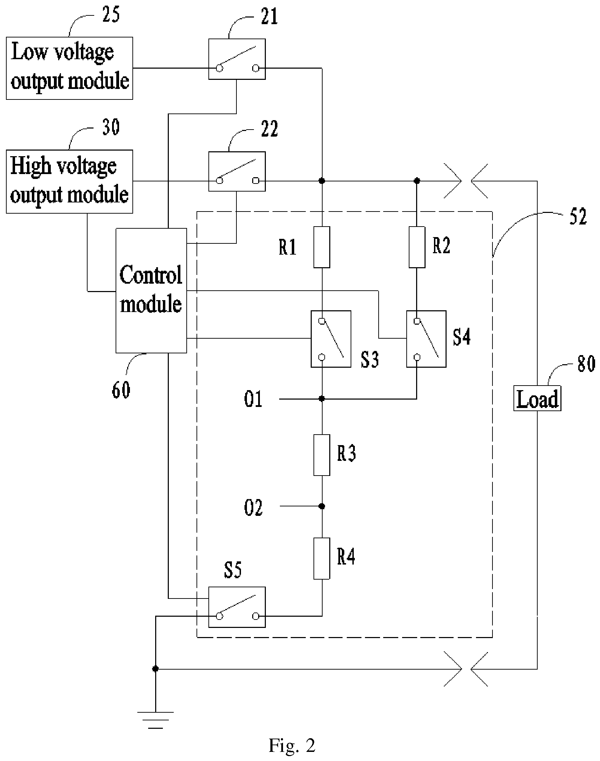

Fig. 2 illustrates a circuit diagram of the detection unit 52 provided by one embodiment of the present invention. The detection unit 52 comprises a third switch S3, a fourth switch S4, a first resistor R1, a second resistor R2, a third resistor R3, and a fourth resistor R4. A first terminal of the first resistor R1 is electrically coupled to the low voltage output module 25 through the first switch 21. A second terminal of the first resistor R1 is electrically coupled to a first terminal of the third resistor R3 through the third switch S3. A first terminal of the second resistor R2 is electrically coupled to the high voltage output module 30 through the second switch 22. A second terminal of the second resistor R2 is electrically coupled to the first terminal of the third resistor R3 through the fourth switch S4. The first terminal of the third resistor R3 functioning as a first output terminal O1 of the detection unit 52, is electrically coupled to the first output unit 56. A second terminal of the third resistor R3 functioning as a second output terminal 02 of the detection unit 52, is electrically coupled to the first output unit 56. The first output terminal O1 and the second output terminal 02 are configured to output the detected state signal to the first output unit 56. The second terminal of the third resistor R3 is further electrically coupled to ground through the fourth resistor R4. The third resistor S3 and the fourth resistor R4 are electrically coupled to the control module 60. When the first switch 21 is turned on, the control module 60 controls the third switch S3 to be turned on. When the second switch 22 is turned on, the control module 60 controls the fourth switch S4 to be turned on.

The detection unit 52 further comprises a fifth switch S5. A first terminal of the fifth switch S5 is electrically coupled to the second terminal of the third resistor R3 through the fourth resistor R4. A second terminal of the fifth switch S5 is electrically coupled to ground. The fifth switch S5 is further electrically coupled to the control module 60. When the first switch 21 is turned on, the control module 60 controls the fifth switch S5 to be turned on. When the second switch 22 is turned on, the control module 60 controls the fifth switch S5 to be turned on.

In one embodiment, each of the first switch 21, the second switch 22, the third switch S3, the fourth switch S4, and the fifth switch S5 may be a bipolar junction transistor (BJT), a metal-oxide-semiconductor field-effect transistor (MOSFET), an insulated gate bipolar transistor (IGBT), a relay, or a contact. In other embodiments, each of the first switch 21, the second switch 22, the third switch S3, the fourth switch S4, and the fifth switch S5 may be other switches having similar functions.

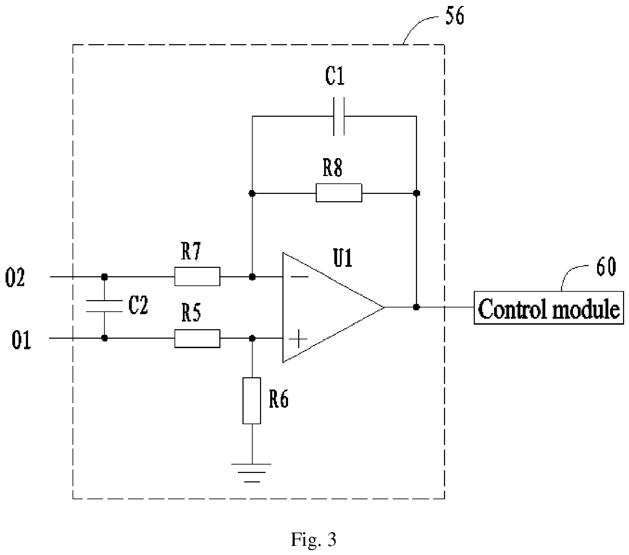

Fig. 3 illustrates a circuit diagram of the first output unit 56 provided by one embodiment of the present invention. The first output unit 56 comprises a first capacitor C1, a fifth resistor R5, a sixth resistor R6, a seventh resistor R7, an eighth resistor R8, and a first operational amplifier U1. A non-inverting input terminal of the first operational amplifier U1 is electrically coupled to the first terminal of the third resistor R3 through the fifth resistor R5, and is electrically coupled to ground through the sixth resistor R6. An inverting input terminal of the first operational amplifier U1 is electrically coupled to the second terminal of the third resistor R3 through the seventh resistor R7. The output terminal of the first operational amplifier U1 is electrically coupled to the inverting input terminal of the first operational amplifier U1 through the eighth resistor R8, electrically coupled to the inverting input terminal of the first operational amplifier U1 through the first capacitor C1, and electrically coupled to the control module 60, to output the detected result to the control module 60.

The first output unit 56 further comprises a second capacitor C2 configured to filter noisy of the detected state signal. A first terminal of second capacitor C2 is electrically coupled to the non-inverting input terminal of the first operational amplifier U1 through the fifth resistor R5. A second terminal of second capacitor C2 is electrically coupled to the inverting input terminal of the first operational amplifier U1 through the resistor R7.

Please refer to FIG. 1 again, the high voltage output module 30 comprises an inverter unit 36 and a second output unit 38. The inverter unit 36 is electrically coupled to the battery pack 12 and the control module 60. The second output unit 38 is electrically coupled to the inverter unit 36, and electrically coupled to the detection module 50 through the second switch 22. When the control module 60 determines that the load 80 is normal and connected, the control module 60 controls the inverter unit 36 to work. The inverter unit 36 converts a direct current received from the battery pack 12 into a high voltage alternating current, and outputs the high voltage alternating current to the second output unit 38. The second output unit 38 processes the high voltage alternating current, and outputs the processed high voltage alternating current to the detection module 50 and the load 80 through the second switch 22.

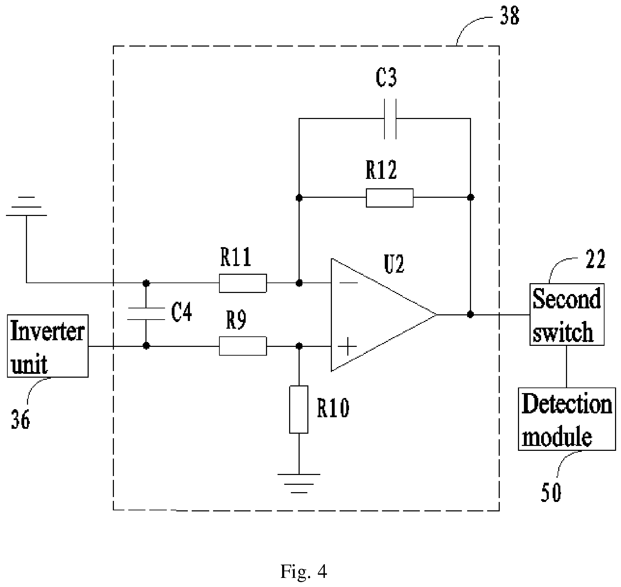

Fig. 4 illustrates a circuit diagram of the second output unit 38 provided by one embodiment of the present invention. The second output unit 38 comprises a third capacitor C3, a ninth resistor R9, a tenth resistor R10, an eleventh resistor R11, a twelfth resistor R12, and a second operational amplifier U2. A non-inverting input terminal of the second operational amplifier U2 is electrically coupled to the inverter unit 36 through the ninth resistor R9, to receive the processed high voltage alternating current from the inverter unit 36. The non-inverting input terminal of the second operational amplifier U2 is further electrically coupled to ground through the tenth resistor R10. An inverting input terminal of the second operational amplifier U2 is electrically coupled to ground through the eleventh resistor R11. The output terminal of the second operational amplifier U2 is electrically coupled to the inverting input terminal of the second operational amplifier U2 through the twelfth resistor R12, electrically coupled to the inverting input terminal of the second operational amplifier U2 through the third capacitor C3, and electrically coupled to the detection module 50 through the second switch 22.

The second output unit 38 further comprises a fourth capacitor C4 configured to filter noisy of the processed high voltage alternating current. A first terminal of the fourth capacitor C4 is electrically coupled to the non-inverting input terminal of the second operational amplifier U2 through the ninth resistor R9. A second terminal of the fourth capacitor C4 is electrically coupled to the inverting input terminal of the second operational amplifier U2 through the eleventh resistor R11.

In one embodiment, each of the second capacitor C2 and the fourth capacitor C4 is configured to filter noisy. In other embodiments, the second capacitor C2 and the fourth capacitance C4 can be omitted, if the signal transmitted in the load detection circuit 20 is less noise or almost no noise.

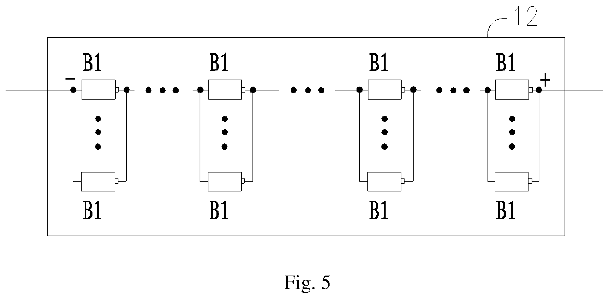

FIG. 5 is a schematic diagram of the battery pack 12 provided by one embodiment of the present invention. The battery pack 12 comprises a plurality of rechargeable batteries configured in a series, parallel or a mixture of both to store and deliver electric energy.

The operation principle of the energy storage device 100 provided by one embodiment of the present invention will be described below.

When a power switch (not shown) of the energy storage device 10 is turned on, the low voltage output module 25 converts a voltage outputted from the battery pack 12 to a low voltage. The control module 60 controls the first switch 21, the third switch S3, and the fifth switch S5 to be turned on periodically. When each of the first switch 21, the third switch S3, and the fifth switch S5 is turned on, the low voltage output module 25 supplies power to the detection unit 52 through the first switch 21, and signal output from the first output terminal O1 and the second output terminal 02 of the detection unit 52 are compared and amplified by the first output unit 56, to generate the detected result. The first output unit 56 outputs the detected result to the control module 60. The control module 60 determines whether the load 80 is normal and connected, according to the detected result.

In one embodiment, a voltage of the detected result V1=(V2-V3)/r3*r8/r7, wherein V2 represents a voltage of the first terminal of the third resistor R3, V3 represents a voltage of the second terminal of the third resistor R3, r3 represents resistance of the third resistor R3, r8 represents resistance of the eighth resistor R8, and r7 represents resistance of the seventh resistor R7.

In one embodiment, the control module 60 compares the voltage of the detected result with a reference value, and determines whether the load 80 is normal and connected, according to the comparison result. When the voltage of the detected result is equal to the reference value, the control module 60 determines that the load 80 is disconnected or the load 80 is connected and open-circuited (that is, the load 80 is abnormal). When the voltage of the detected result is equal to zero, the control module 60 determines that the load 80 is short-circuited (that is, the load 80 is abnormal). When the voltage of the detected result is not equal to the reference value and not equal to zero, the control module 60 determines that the load 80 is normal and connected. In other embodiments, the control module 60 may determine whether the load 80 is normal and connected, according to the detected result, by other means.

In one embodiment, the control module 60 controls the first switch 21 to be turned on once every 0.1 second. That is, a cycle of the control module 60 controlling the first switch 21 to be turned on is 0.1 second. In other embodiments, length of time of the cycle of the control module 60 controlling the first switch 21 to be turned on, can be adjusted according to actual need, for example, 0.2 second, 0.3 second, and the like.

When the control module 60 determines the load 80 is normal and connected, the control module 60 controls the first switch 21 and the third switch S3 to be turned off, controls the inverter unit 36 to work, and controls the second switch 22 and the fourth switch S4 to be turned on. The inverter unit 36 converts the direct current output from the battery pack 12 into the high voltage alternating current, and outputs the high voltage alternating current to the second output unit 38. The second output unit 38 amplifies the high voltage alternating current, and outputs the amplified high voltage alternating current to the detection unit 52 and the load 80 through the second switch 22. The detection unit 52 is powered by the high voltage output module 30. The signal output from the first output terminal O1 and the second output terminal 02 of the detection unit 52 are compared and amplified by the first output unit 56, to generate the detected result. The control module 60 determines whether the load 80 is normal and connected, according to the detected result.

When the control module 60 determines that the load 80 is connected and short-circuited, or the load 80 is connected and open-circuited, or the load 80 is disconnected, the control module 60 controls the inverter unit 36 to stop working, controls the second switch 22, the fourth switch S4, and the fifth switch S5 to be turned off, and controls the first switch 21, the third switch S3, and the fifth switch S5 to be turned on periodically. The detection unit 52 is powered by the low voltage output module 25, detects the state of the load, and outputs a detected state signal to the first output unit 56, when the first switch 21, the third switch S3, and the fifth switch S5 are turned on. The detected state signal output from the first output terminal 01 and the second output terminal 02 of the detection unit 52 are compared and amplified by the first output unit 56, to generate the detected result. The control module 60 determines whether the load 80 is normal and connected, according to the detected result.

As detail above, the detection module 50 detects the states of the load 80 and outputs the detected result to the control module 60; the control module 60 determines whether the load 80 is normal and connected, according to the detected result; and controls operation states the first switch 21, the second switch 22, the third switch S3, the fourth switch S4, and the fifth switch S5, and the high voltage output module 30, according to whether the load 80 is normal and connected. When the load 80 is normal and connected, the control module 60 controls the high voltage output module 30 works to power the detection module 50 and the load 80. When the load 80 is connected and short-circuited, or the load 80 is connected and open-circuited, or the load 80 is disconnected, the control module 60 controls the high voltage output module 30 to stop working, and controls the low voltage output module 25 to power the detection module 50 periodically. That is, the high voltage output module 30 does not work all the time to supply power; and when the high voltage output module 30 does not work, the low voltage output module 25 powers the detection module 50 periodically. Therefore, the energy storage device 100 can detect the states of the load 80 and power is save.

It will be apparent to those skilled in the art that various modification and variations can be made in the multicolor illumination device and related method of the present invention without departing from the spirit or scope of the invention. Thus, it is intended that the present invention cover modifications and variations that come within the scope of the appended claims and their equivalents.

## Claims

1. A load detection circuit (20), comprising:
a first switch (21) and a second switch (22);
a low voltage output module (25) configured to output a low voltage;
a high voltage output module (30) configured to output a high voltage;
a detection module (50) electrically coupled to the low voltage output module (25) through the first switch (21), and electrically coupled to the high voltage output module (30) through the second switch (22); and
a control module (60) electrically coupled to the first switch (21), the second switch (22), the detection module (50), and the high voltage output module (30);
wherein the control module (60) controls the first switch (21) to be turned on periodically; when the first switch (21) is turned on, the detection module (50) is powered by the low voltage output module (25) through the first switch (21), the detection module (50) detects states of a load (80) and outputs a detected result to the control module (60), and the control module (60) determines whether the load (80) is normal and connected, according to the detected result;
wherein when the control module (60) determines that the load (80) is normal and connected, the control module (60) controls the high voltage output module (30) to work, controls the first switch (21) to be turned off, and controls the second switch (22) to be turned on, the detection module (50) and the load (80) are powered by the high voltage output module (30) through the second switch (22); and
wherein when the control module (60) determines that the load (80) is connected and short-circuited, or the load (80) is connected and open-circuited, or the load (80) is disconnected, the control module (60) controls the high voltage output module (30) to stop working, controls the second switch (22) to be turned off, and controls the first switch (21) to be turned on periodically.

2. The load detection circuit (20) of claim 1, wherein the detection module (50) comprises:
a first output unit (56); and
a detection unit (52) electrically coupled to the low voltage output module (25) through the first switch (21), electrically coupled to the high voltage output module (30) through the second switch (22), and electrically coupled to the control module (60) though the first output unit (56);
wherein the detection unit (52) is configured to detect the states of the load and output a detected state signal to the first output unit (56), and the first output unit (56) is configured to process the detected state signal to generate the detected result, and output the detected result to the control module (60).

3. The load detection circuit (20) of claim 2, wherein the detection unit (52) comprises:
a third switch (S3) electrically coupled to the control module (60);
a fourth resistor (R4) electrically coupled to the control module (60);
a first resistor (R1) comprising a first terminal electrically coupled to the low voltage output module (25) through the first switch (21), and a second terminal;
a second resistor (R2) comprising a first terminal electrically coupled to the high voltage output module (30) through the second switch (22);
a third resistor (R3) comprising a first terminal electrically coupled to the second terminal of the first resistor (R1) through the third switch (S3), electrically coupled to the second terminal of the second resistor (R2) through the fourth switch (S4), and electrically coupled to the first output unit (56), and a second terminal electrically coupled to the first output unit (56); and
a fourth resistor (R4) comprising a first terminal electrically coupled to the second terminal of the third resistor (R3), and a second terminal electrically coupled to ground;
wherein the first terminal and the second terminal of the third resistor (R3) are configured to output the detected state signal to the first output unit (56);
wherein when the first switch (21) is turned on, the control module (60) controls the third switch (S3) to be turned on; and
wherein when the second switch (22) is turned on, the control module (60) controls the fourth switch (S4) to be turned on.

4. The load detection circuit (20) of claim 3, wherein the detection unit (52) further comprises:
a fifth switch (S5) comprising a first terminal electrically coupled to the second terminal of the fourth resistor (R4), and a second terminal electrically coupled to ground;
wherein the fifth switch (S5) is further electrically coupled to the control module (60); when the first switch (21) is turned on, the control module (60) controls the fifth switch (S5) to be turned on; and when the second switch (22) is turned on, the control module (60) controls the fifth switch (S5) to be turned on.

5. The load detection circuit (20) of claim 4, wherein each of the first switch (21), the second switch (22), the third switch (S3), the fourth switch (S4), and the fifth switch (S5) is a bipolar junction transistor, a metal-oxide-semiconductor field-effect transistor, an insulated gate bipolar transistor, a relay, or a contact.

6. The load detection circuit (20) of claim 3, wherein the first output unit (56) comprises:
a first capacitor (C1);
a fifth resistor (R5), a sixth resistor (R6), a seventh resistor (R7), and an eighth resistor (R8); and
a first operational amplifier (U1) comprising a non-inverting input terminal electrically coupled to the first terminal of the third resistor (R3) through the fifth resistor (R5), and electrically coupled to ground through the sixth resistor (R6); an inverting input terminal electrically coupled to the second terminal of the third resistor (R3) through the seventh resistor (R7); and an output terminal electrically coupled to the inverting input terminal of the first operational amplifier (U1) through the eighth resistor (R8), electrically coupled to the inverting input terminal of the first operational amplifier (U1) through the first capacitor (C1), and electrically coupled to the control module (60), to output the detected result to the control module (60).

7. The load detection circuit (20) of claim 6, wherein the first output unit (56) further comprises:
a second capacitor (C2) comprising a first terminal electrically coupled to the non-inverting input terminal of the first operational amplifier (U1) through the fifth resistor R5, and a second terminal electrically coupled to the inverting input terminal of the first operational amplifier (U1) through the resistor (R7);
wherein the second capacitor (C2) is configured to filter noisy of the detected state signal.

8. The load detection circuit (20) of claim 1, wherein the high voltage output module (30) comprises:
an inverter unit (36) electrically coupled to the control module (60); and
a second output unit (38) electrically coupled to the inverter unit (36), and electrically coupled to the detection module (50) through the second switch (22);
wherein when the control module (60) determines that the load (80) is normal and connected, the control module (60) controls the inverter unit (36) to work; the inverter unit 36 converts received direct current into a high voltage alternating current, and outputs the high voltage alternating current to the second output unit (38); the second output unit (38) processes the high voltage alternating current, and outputs the processed high voltage alternating current to the detection module (50) and the load (80) through the second switch (22).

9. The load detection circuit (20) of claim 8, wherein the second output unit (38) comprises:
a third capacitor (C3);
a ninth resistor (R9), a tenth resistor (R10), an eleventh resistor (R11), and a twelfth resistor (R12); and
a second operational amplifier (U2) comprising a non-inverting input terminal electrically coupled to the inverter unit (36) through the ninth resistor (R9), to receive the processed high voltage alternating current from the inverter unit (36), and electrically coupled to ground through the tenth resistor (R10); an inverting input terminal electrically coupled to ground through the eleventh resistor (R11); and an output terminal electrically coupled to the inverting input terminal of the second operational amplifier (U2) through the twelfth resistor (R12), electrically coupled to the inverting input terminal of the second operational amplifier (U2) through the third capacitor (C3), and electrically coupled to the detection module (50) through the second switch (22).

10. The load detection circuit (20) of claim 9, wherein the second output unit (38) further comprises:
a fourth capacitor (C4) comprising a first terminal electrically coupled to the non-inverting input terminal of the second operational amplifier (U2) through the ninth resistor (R9), and a second terminal electrically coupled to the inverting input terminal of the second operational amplifier (U2) through the resistor (R10);
wherein the fourth capacitor (C4) is configured to filter noisy of the processed high voltage alternating current.

11. An energy storage device (100), comprising:
an energy storage module (10) comprising a battery pack (12); and
a load detection circuit (20) comprising:
a first switch (21) and a second switch (22);
a low voltage output module (25) electrically coupled to the battery pack (12), and configured to convert a voltage outputted from the battery pack (12) into a low voltage;
a high voltage output module (30) electrically coupled to the battery pack (12), and configured to convert the voltage outputted from the battery pack (12) into a high voltage;
a detection module (50) electrically coupled to the low voltage output module (25) through the first switch (21), and electrically coupled to the high voltage output module (30) through the second switch (22); and
a control module (60) electrically coupled to the first switch (21), the second switch (22), the detection module (50), and the high voltage output module (30);
wherein the control module (60) controls the first switch (21) to be turned on periodically, when the first switch (21) is turned on, the detection module (50) is powered by the low voltage output module (25) through the first switch (21), the detection module (50) detects states of a load (80) and outputs a detected result to the control module (60), and the control module (60) determines whether the load (80) is normal and connected, according to the detected result;
wherein when the control module (60) determines the load (80) being normal and connected, the control module (60) controls the high voltage output module (30) to work, controls the first switch (21) to be turned off, and controls the second switch (22) to be turned on, the detection module (50) and the load (80) are powered by the high voltage output module (30) through the second switch (22); and
wherein when the control module (60) determines that the load (80) is connected and short-circuited, or the load (80) is connected and open-circuited, or the load (80) is disconnected, the control module (60) controls the high voltage output module (30) to stop working, controls the second switch (22) to be turned off, and controls the first switch (21) to be turned on periodically.

12. The energy storage device (100) of claim 11, wherein the detection module (50) comprises:
a first output unit (56); and
a detection unit (52) electrically coupled to the low voltage output module (25) through the first switch (21), electrically coupled to the high voltage output module (30) through the second switch (22), and electrically coupled to the control module (60) though the first output unit (56);
wherein the detection unit (52) is configured to detect the states of the load and output a detected state signal to the first output unit (56), and the first output unit (56) is configured to process the detected state signal to generate the detected result, and output the detected result to the control module (60).

13. The energy storage device (100) of claim 12, wherein the detection unit (52) comprises:
a third switch (S3) electrically coupled to the control module (60);
a fourth resistor (R4) electrically coupled to the control module (60);
a first resistor (R1) comprising a first terminal electrically coupled to the low voltage output module (25) through the first switch (21), and a second terminal;
a second resistor (R2) comprising a first terminal electrically coupled to the high voltage output module (30) through the second switch (22);
a third resistor (R3) comprising a first terminal electrically coupled to the second terminal of the first resistor (R1) through the third switch (S3), electrically coupled to the second terminal of the second resistor (R2) through the fourth switch (S4), and electrically coupled to the first output unit (56), and a second terminal electrically coupled to the first output unit (56); and
a fourth resistor (R4) comprising a first terminal electrically coupled to the second terminal of the third resistor (R3), and a second terminal electrically coupled to ground;
wherein the first terminal and the second terminal of the third resistor (R3) are configured to output the detected state signal to the first output unit (56);
wherein when the first switch (21) is turned on, the control module (60) controls the third switch (S3) to be turned on; and
wherein when the second switch (22) is turned on, the control module (60) controls the fourth switch (S4) to be turned on.

14. The energy storage device (100) of claim 13, wherein the detection unit (52) further comprises:
a fifth switch (S5) comprising a first terminal electrically coupled to the second terminal of the fourth resistor (R4), and a second terminal electrically coupled to ground;
wherein the fifth switch (S5) is further electrically coupled to the control module (60); when the first switch (21) is turned on, the control module (60) controls the fifth switch (S5) to be turned on; and when the second switch (22) is turned on, the control module (60) controls the fifth switch (S5) to be turned on.

15. The energy storage device (100) of claim 13, wherein the first output unit (56) comprises:
a first capacitor (C1);
a fifth resistor (R5), a sixth resistor (R6), a seventh resistor (R7), and an eighth resistor (R8); and
a first operational amplifier (U1) comprising a non-inverting input terminal electrically coupled to the first terminal of the third resistor (R3) through the fifth resistor (R5), and electrically coupled to ground through the sixth resistor (R6); an inverting input terminal electrically coupled to the second terminal of the third resistor (R3) through the seventh resistor (R7); and an output terminal electrically coupled to the inverting input terminal of the first operational amplifier (U1) through the eighth resistor (R8), electrically coupled to the inverting input terminal of the first operational amplifier (U1) through the first capacitor (C1), and electrically coupled to the control module (60), to output the detected result to the control module (60).

16. The energy storage device (100) of claim 15, wherein the first output unit (56) further comprises:
a second capacitor (C2) comprising a first terminal electrically coupled to the non-inverting input terminal of the first operational amplifier (U1) through the fifth resistor R5, and a second terminal electrically coupled to the inverting input terminal of the first operational amplifier (U1) through the resistor (R7);
wherein the second capacitor (C2) is configured to filter noisy of the detected state signal.

17. The energy storage device (100) of claim 11, wherein the high voltage output module (30) comprises:
an inverter unit (36) electrically coupled to the battery pack (12) and the control module (60); and
a second output unit (38) electrically coupled to the inverter unit (36), and electrically coupled to the detection module (50) through the second switch (22);
wherein when the control module (60) determines that the load (80) is normal and connected, the control module (60) controls the inverter unit (36) to work; the inverter unit 36 converts a direct current received from the battery pack (12) into a high voltage alternating current, and outputs the high voltage alternating current to the second output unit (38); the second output unit (38) processes the high voltage alternating current, and outputs the processed high voltage alternating current to the detection module (50) and the load (80) through the second switch (22).

18. The energy storage device (100) of claim 17, wherein the second output unit (38) comprises:
a third capacitor (C3);
a ninth resistor (R9), a tenth resistor (R10), an eleventh resistor (R11), and a twelfth resistor (R12); and
a second operational amplifier (U2) comprising a non-inverting input terminal electrically coupled to the inverter unit (36) through the ninth resistor (R9), to receive the processed high voltage alternating current from the inverter unit (36), and electrically coupled to ground through the tenth resistor (R10); an inverting input terminal electrically coupled to ground through the eleventh resistor (R11); and an output terminal electrically coupled to the inverting input terminal of the second operational amplifier (U2) through the twelfth resistor (R12), electrically coupled to the inverting input terminal of the second operational amplifier (U2) through the third capacitor (C3), and electrically coupled to the detection module (50) through the second switch (22).

19. The energy storage device (100) of claim 18, wherein the second output unit (38) further comprises:
a fourth capacitor (C4) comprising a first terminal electrically coupled to the non-inverting input terminal of the second operational amplifier (U2) through the ninth resistor (R9), and a second terminal electrically coupled to the inverting input terminal of the second operational amplifier (U2) through the eleventh resistor (R11);
wherein the fourth capacitor (C4) is configured to filter noisy of the processed high voltage alternating current.

20. The energy storage device (100) of claim 11, wherein the battery pack (12) comprising a plurality of rechargeable batteries (B1) configured in a series, parallel or a mixture of both to store and deliver electric energy.
